# EUROPEAN PATENT SPECIFICATION

(11) **EP 4 100 755 B1**
(45) Date of publication and mention of the grant of the patent: **27.03.2024**
(21) Application number: 20705893.4
(22) Date of filing: 07.02.2020
(51) Int. Cl.: G01R 33/3875, G01R 33/54, G01R 33/24

(54) **METHOD TO SHIM A MAGNETIC FIELD AND MAGNETIC RESONANCE ARRANGEMENT**
VERFAHREN ZUM AUSGLEICHEN EINES MAGNETFELDES UND MAGNETRESONANZANORDNUNG
PROCÉDÉ D'HOMOGÉNÉISATION D'UN CHAMP MAGNÉTIQUE ET AGENCEMENT DE RÉSONANCE MAGNÉTIQUE (RM)

(43) Date of publication of application: 14.12.2022
(73) Proprietor: MR Shim GmbH, 72760 Reutlingen (DE)
(72) Inventor: NASSIRPOUR, Sahar, 72127 Kusterdingen (DE); CHANG, Yu-Chun, 72070 Tübingen (DE)
(74) Representative: Mertzlufft-Paufler, Cornelius
(86) International application number: PCT/EP2020/053212
(87) International publication number: WO 2021/155955

(56) References cited:
- US-A1- 2013 181 715
- US-A1- 2015 054 510
- US-A1- 2015 301 135
- US-A1- 2020 025 845
- US-B1- 6 223 065
- LIEKE VAN DEN WILDENBERG ET AL: "B-0 shimming of the liver using a local array of shim coils in the presence of respiratory motion at 7T", PROC. INTL. SOC. MAG. RESON. MED. 27 (2019), vol. 0221, 26 April 2019 (2019-04-26), XP055690548,

## Description

The invention relates to a method to shim a magnetic field inside a magnetic resonance apparatus, whereby a shim insert comprising several magnetic coils is placed inside a bore of the magnetic resonance apparatus.

The bore might be cylindrically shaped. It might also have a different shape. The bore can also be open on three sides such as in open MR systems. The MR apparatus may for example be an MR imaging apparatus or an MR spectrometer.

Within the context of this invention, the abbreviation "MR" means "magnetic resonance".

The invention further relates to a magnetic resonance arrangement with a magnetic resonance apparatus and a shim insert comprising several magnetic coils.

Such MR arrangements and shimming methods are known in the art. A shimming method may be characterized to be a method where an inhomogeneity of a magnetic field, that is essentially constant, is corrected, in particular in a region-of-interest.

Usually, an MR apparatus is equipped with a pre-installed shim system that is often designed to generate magnetic correction fields that correspond to the lowest spherical harmonics.

In the recent years, multi-coil shim inserts have been proposed that have the advantage that they can be brought closer to the subject that is being imaged with the MR apparatus. Such shim inserts are usually designed to be movable such that the insert can be moved into the MR apparatus if needed.

Such inserts pose novel technical challenges that need to be solved. In contrast to pre-installed shim coils, multi-coil designs may consist of simple coil loops or other usually simple designs. The designs usually do not generate magnetic fields that follow an analytical mathematical function as the pre-installed shim coils.

Moreover, in order for a shim insert to generate the best possible results, the insert may need to be placed at different locations in the MR apparatus depending on the region of the subject that is being imaged. Inserts may even be built flexible such that the individual coils can be wrapped around a body of the subject.

The design of the shim insert might therefore change between different measurements and for different subjects. The design might change even during a single measurement when it is wrapped around the subject and the subject moves during the measurement.

In contrast to pre-installed shim coils, the magnetic field distribution that is generated by a shim insert is therefore often not fixed and not exactly known prior to an MR measurement of a subject.

However, for the execution of a shimming method, it is important to have information about the shape of the magnetic fields that are generated by the coils of the shim insert because those magnetic fields are used to correct for a magnetic field heterogeneity of the magnetic field that is generated by the main magnet of the MR apparatus. The main magnet is typically superconducting and is in most applications used to orient the spins of hydrogen nuclei. This magnetic field should be as constant as possible in the imaging region. However, due to the wiring of the main magnet and due to susceptibility variations that are caused by the imaged subject, heterogeneities in the order of ppm occur for typical magnet sizes and magnet strengths that typically range between 0,5 Tesla and 7 Tesla.

Usually, when the patient is positioned in the MR apparatus for examination, before executing a scan where the diagnostic MR data is acquired, the radiologist runs an adjustment pre-scan to acquire an uncorrected magnetic field heterogeneity distribution of the magnetic field. In addition to this pre-scan it is known to perform another pre-scan to collect information about the field distribution of the coils of a shim insert. To this end, it is known to drive one by one each coil with a known electrical current. The magnetic field produced by them is measured using the MR apparatus. This step is very time consuming. This step may be done on a phantom object before the human subject enters the scanner to save time.

The measured field maps for each shim coil are then saved in memory. This requires a lot of computer memory and slows the computation down. When the human is being scanned, these saved fields are used to calculate optimal shim currents for the individual coils.

Another drawback of the state of the art is that when the patient is inside the MR apparatus, the local shim coils can move and may therefore not be in the same position any more as at the time, the pre-scan was performed. This is particularly the case if the shim coils are flexibly wrapped around the body of the subject. The resulting inconsistencies will make the shimming inaccurate.

From US 2015/054510 A1, methods and magnetic resonance tomography systems with a shim system are disclosed, where the shim system includes at least one global shim coil in an area surrounding the bore of the magnetic resonance tomography system, and where the shim system includes a local shim coil in a local coil of the magnetic resonance tomography system with a shim controller, with the shim controller embodied to define shim currents for the global shim coil and for the local shim coil.

US 2015/301135 A1 describes a method and a magnetic resonance apparatus which compensate for inhomogeneities in a magnetic field generated by the magnetic resonance apparatus with a shim coil of the magnetic resonance apparatus. The shim coil is arranged at an object under investigation. A position and an orientation of the shim coil are automatically determined. The inhomogeneities of the magnetic field are determined. The inhomogeneities are compensated for via the shim coil depending on the position and the orientation of the shim coil.

In "B-0 shimming of the liver usinga local array of shim coils in the presence of respiratory motion at 7T", PROC. INTL. SOC. MAG. RESON. MED. 27 (2019), vol. 0221, van den Wildenberg et al. describe that in conjunction with static second order shimming, local arrays of shim coils can substantially improve the magnetic field uniformity in the liver at different breathing states.

In US 2013/0181715 A1, magnetic resonance tomography (MRT) local coil positioning by RFID is enabled with a positioning device to detect a position of a first object relative to a position of an additional object that includes at least one RFID tag arranged on the first object and/or at least one RFID reader arranged on the additional object.

US 2020/0025845 A1 shows a method including determining a position of a local coil, a coil position, and a position of a body part of a patient, a body part position.

US 6 223 065 B1 describes a method of imaging a subject in an imaging system having a magnetic field and a plurality of receive coils movable with respect to the magnetic field including sensing the magnetic field by means of at least one sensor having a known position with respect to the subject.

In view of the above, it is an object of the invention to avoid the drawbacks of current systems and methods and to find an improved shimming method and MR arrangement.

To achieve this object, a first aspect of the invention proposes the technical features according to claim 1. In particular, according to the invention it is provided that for a method to shim a magnetic field of the type described at the beginning, that after placing the shim insert inside the bore, geometrical parameters of the individual magnetic coils of the shim insert are determined. Those geometrical parameters may then be used to determine optimal shim currents for the magnetic coils. The geometrical parameters may be positions and/or orientations of the individual coils.

The determination of geometrical parameters of the individual coils can have various advantages for a shimming method. Geometrical parameters such as positions and/or orientations of the individual coils reduce the amount of information that is required for a high-quality shim to a minimum. This may reduce the required storage space, accelerate computation time as well as scanning time.

The shim insert comprises several magnetic coils. At least two coils are therefore sufficient. Preferably, however, the shim insert comprises at least three or even a multitude such as at least ten coils. More coils will result in more customizable magnetic field correction fields that can be generated with the shim insert.

An uncorrected magnetic field heterogeneity distribution of the magnetic field may be measured and used to determine the optimal shim currents.

The optimal shim currents may be determined by first generating a digital model of the shim insert such that magnetic field sensitivities of the individual coils can be calculated automatically, whereby the magnetic field sensitivities of the individual coils depend on the geometrical parameters. A magnetic field sensitivity of a magnetic coil may be characterized by the magnetic field that is generated by the coil per unit current. When a magnetic coil is driven with a certain current, the resulting magnetic field is given by the magnetic field sensitivity of the coil multiplied by the current. The digital model can therefore be used to calculate the magnetic field that is generated by the shim insert for all possible shim current values. The digital model might by an analytic model. It might also be approximated, for example by using a finite number of discrete line segments. The magnetic fields or the magnetic field sensitivities may then for example be calculated using the Biot-Savart Law.

After determination of the digital model, optimal shim currents may then be determined by finding optimal shim currents that minimize a deviation between the uncorrected measured magnetic field heterogeneity distribution and the magnetic field that is generated by the digital model of the shim insert for the geometrical parameters. Preferably, this is done by way of an automated optimization method. Any known suitable optimization method may be used to find optimal shim currents. For example, a global optimization method such as differential evolution or particle swarm may be used. Also local optimization methods such as gradient descent or Adam optimizers may be used. The deviation may be calculated using an adequate difference norm in a region-of-interest. Apart from using a spatial information about the shim coils to determine optimal shim currents, also temporal switching characteristics of the shim coils may be used in case dynamics of the shim updates are to be considered.

Alternatively, optimal shim currents may be determined by first training a neural network, according to a second aspect of the invention as set forth in independent claim 2. The neural network is preferably a deep-learning network. Training may for example be done by measuring partially corrected magnetic field heterogeneity distributions of the magnetic field with varying shim currents. Training may also be done by directly measuring the magnetic fields generated by the individual coils for different shim currents. According to the second aspect of the invention, training is done by simulating partially corrected magnetic field heterogeneity distributions using a digital model of the shim insert, for example the above-mentioned digital model, by varying shim currents in the model.

Optimal shim currents may then be determined by using the trained neural network to determine the optimal shim currents for the measured uncorrected magnetic field heterogeneity distribution.

The above embodiments have the advantage that it is not necessary to store field maps for each individual coil. It is sufficient to store the model of the shim insert and the geometrical parameters. Those are sufficient to generate the magnetic field distributions of each coil. Moreover, diagnostic MR data acquisition can be accelerated by measuring geometrical parameters of the shim insert rather than measuring magnetic fields that are generated by the shim insert.

According to a further embodiment of the invention, distances between locations on the individual coils to a location with known spatial coordinates are measured and the measured distances are used to determine the geometrical parameters.

There may be more than one location on an individual coil for which the distance is measured to the known location. There may also be more than one location with known spatial coordinates to which distances to locations on the coils are measured. For the determination of the geometrical parameters for example a triangulation algorithm may be used.

The distances may for example be measured using a radiofrequency signal. A frequency between 0,5 GHz and 2 GHz, preferably between 0,8 GHz and 1,2 GHz, may be beneficial because there is not much interaction with the subject and the MR apparatus. Therefore, the signal can be communicated unhindered between the different locations of interest.

The distances may be measured by attaching signal communication devices onto the individual coils. A further signal communication device may be placed at the location or locations with known spatial coordinates. Specific types of signal communication devices will be described in more detail further below.

The above embodiments are advantageous as a distance measurement is simple to implement and from the distances the geometrical parameters of the coils such as position and orientation can readily be deduced. It may be useful to use more than one locations on a coil because a coil such as a coil loop has in total six degrees of freedom, three for its position and three for its orientation, that need to be determined. Some degrees of freedom may be eliminated because the coils can not move completely independent from each other in the shim insert. However there are still several degrees of freedom that need to be determined for each coil. Therefore, distance measurements to different locations on the coil will contain more information such that the accuracy of the determined geometrical parameters will increase with an increased number of distance measurements. Different distance measurements are also possible in case there is more than one location with known spatial coordinates from which distances to the coils are measured.

A location with known spatial coordinates may for example be a location in a room where the MR apparatus is placed or also a location on the MR apparatus.

According to a further embodiment of the invention a magnetic gradient field is generated, a field strength of the magnetic gradient field is measured at one or more locations on the individual coils and the measured field strengths are used to determine the geometrical parameters. Such an embodiment has the advantage that it can result in the determination of very accurate geometrical parameters, in particular in real-time. Preferably, the magnetic gradient fields have a spatially constant gradient. Magnetic field sensors may be attached to the individual coils. Also more than a single sensor may be attached at different locations on the coil elements. The magnetic gradient field may be temporally varying. In particular, it may be generated according to a pre-determined gradient switching pattern. The pattern may coincide with a signal localization pattern. It may, for example, be a Cartesian, radial, spiral or any other k-space trajectory pattern.

The measured field strengths will be proportional to the distance to the isocenter of the magnet bore when a constant gradient is used. This information will be sufficient to deduce the locations and orientations of the individual shim coils. The locations might still be scaled with a certain factor. This factor may be found by using some additional information about the coil geometry. For example, if the distance between two magnetic field sensors is known, this information may be used for correct scaling.

If a single-axis magnetic field sensor is used, the position and orientation of a coil in one direction can be determined. If a multi-axis magnetic field sensor is used, the position and orientation can be calculated for multiple directions. Preferably, a three-axis magnetic field sensor is used.

According to a further embodiment of the invention a temporally varying magnetic gradient field is generated, the signals that are induced in the coils by the magnetic gradient field are measured and the measured signals are used to determine the geometrical parameters. The magnetic gradient field preferably has a spatially constant gradient. Such an embodiment can be beneficial because the components that are already available can be used and there is no need to add any additional measurement device. According to Faraday's law of induction a temporally varying magnetic fields induces an electrical current in a conductor. The induced current is proportional to the rate of change of the magnetic field. Therefore, in case a constant gradient field is applied, the induced current will be proportional to the distance to the isocenter of the magnet bore. The induced currents may be measured and based on this, the geometrical parameters of the individual coils can be calculated. The spatial coordinates of the coils are proportional to the strength of the induced currents. Orientations of the coils may be found by changing the direction of the magnetic field gradients and searching for the direction that induces the highest field strength. The induced current will depend on the relative orientations of the coil and the applied gradient fields.

Accurate real-time shimming will be possible in case that optimal shim currents are updated at several time points during an MR acquisition. Preferably, the geometrical parameters are determined at the several time points. Alternatively or additionally uncorrected magnetic field heterogeneity distributions are measured at the several time points.

The method to shim a magnetic field and the described variants thereof may be executed using an MR arrangement that has been described at the beginning, but also using an MR arrangement such as those described below.

To achieve the above-mentioned object of the invention, the invention proposes the technical features according to claim 11. In particular, according to the invention it is provided that for an MR arrangement of the type described at the beginning that the MR arrangement is configured to execute the method that is formed according to this invention, i.e. that has the technical features of the inventive method as described here and/or that has the technical features of the patent claims that protect the inventive method. Such an MR arrangement shares the advantages that have already been described above with respect to corresponding embodiments of the inventive method.

To achieve the above-mentioned object of the invention, the invention further proposes the technical features according to claim 12. In particular, according to the invention it is provided that for an MR arrangement of the type described at the beginning or of a type that has been described before, in particular of the type according to claim 11, that one or more signal communication devices and/or magnetic field sensors are attached to the coils of the shim insert. The signal communication device may be an active or passive signal transponder such as an emitting marker. Useful may be in particular an RFID chip. The RFID chip or other signal communication device may work at a radiofrequency signal having a frequency between 0,5 GHz and 2 GHz, preferably between 0,8 GHz and 1,2 GHz. Preferably, a further signal communication device is placed at a location with known spatial coordinates and/or at a fixed location. Such MR arrangements may be used in various ways. Some examples were already described with respect with a shimming method.

The invention will now be described in more detail on the basis of a small number of specific embodiments, but is not restricted to these few specific embodiments. Further embodiments are provided by combining the features of one or more of the claims with one another and/or with one or more features of the variants of the inventive method and the inventive MR arrangement that have been described before and that will be described below.

In the figures
- Fig. 1: shows an embodiment of an MR arrangement that is constructed according to this invention;
- Fig. 2: illustrates an embodiment of the invention using a magnetic field sensor attached to a coil;
- Fig. 3: illustrates an embodiment of the invention where RFID chips and an RFID reader are used to determine geometrical parameters of the coils of a shim insert.

In the following, the same reference signs may be used for elements which correspond to each other in terms of their function even though their configuration or shape might differ.

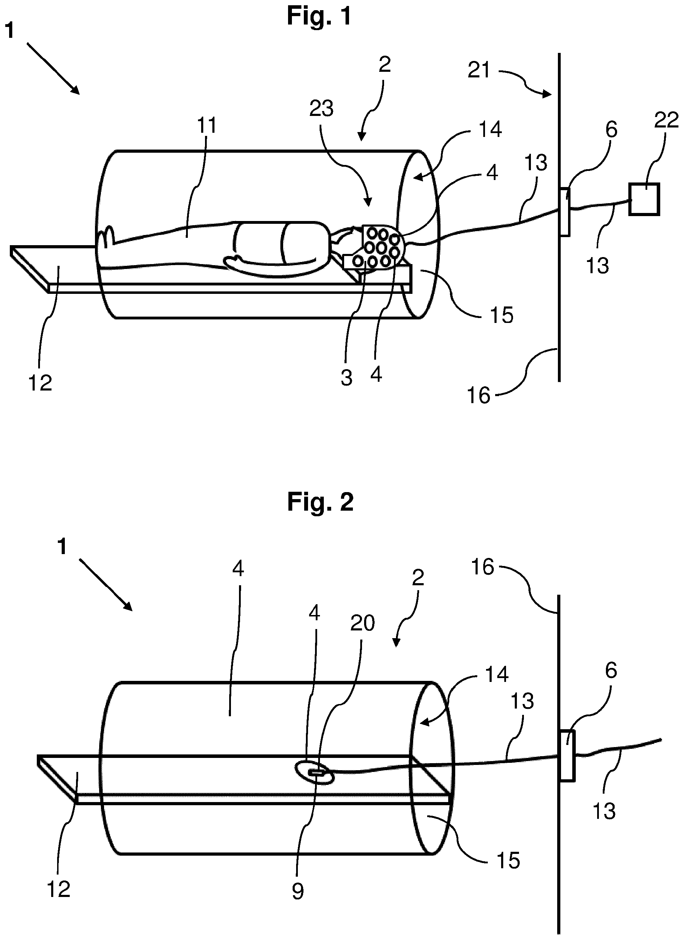

Different embodiments of an MR arrangement 1 that are constructed according to this invention are given in Fig. 1 to Fig. 3. Embodiments of a method to shim a magnetic field will be described in more detail below by also referring to the embodiments of the MR arrangements 1 according to Fig. 1 to Fig. 3.

The MR arrangement 1 shown in Fig. 1 comprises an MR apparatus 2 that forms an MR imaging scanner. From the MR imaging scanner only the wall 15 of the cylindrically-shaped bore 14 is shown. The bore 14 encloses an imaging volume.

The MR apparatus 2 has the usual components. Among them is a superconducting main magnet which generates a magnetic field that is essentially constant in the imaging region. This magnetic field typically has a field strength between 0,5 Tesla and 7 Tesla and is usually used to orient the spins of the hydrogen nuclei of the measurement object such as the human subject 9 that may lie on the patient table 12. The MR apparatus 2 also has a radiofrequency (rf) transmit coil for flipping the spins such that they emit an MR signal that may then be acquired with an rf receive coil. The MR apparatus 2 is further equipped with a gradient system that has the usual x-, y- and z-gradients coils which may be used among others for signal localization that allows reconstruction of an MR image. The gradient coils each generate a magnetic gradient field with a constant spatial gradient. For the reconstruction, the acquisition channel is connected to a computer where image reconstruction may be performed. The MR apparatus 2 also has a pre-installed shim system as it is well known in the art.

Apart from the pre-installed shim system the MR apparatus 2 is further equipped with a multi-coil shim insert 3 that comprises a multitude of individual shim coils elements 4 that might each be driven with a different shim current. For an MR measurement, the shim insert 3 is brought in close proximity to the body of the subject 9. In Fig. 1 the shim insert 3 is constructed for imaging the brain of a human subject. To this end, the individual shim coils 4 are arranged on a helmet holder.

Each shim coil 4 receives the shim currents through a conductor. The conductors are joined in a common cable 13 that enters a filter device 6. The filter device 6 is attached to the wall 16 of the room where the MR apparatus 2 is placed. The filter device 6 is connected to the shim amplifiers and to a signal reception and evaluation unit 22 in the next room via another cable 13.

Shimming with the MR arrangement 1 shown in Fig. 1 may be performed in the following way.
- The shim insert 3 is placed in an imaging volume 23 inside the bore 14 of the MR apparatus 2.
- An uncorrected magnetic field distribution is measured with the MR apparatus 2 in a usual way. The resulting distribution map is also known as a "B0 field map". The B0 field map is usually measured with the subject 11 already being placed in the magnet bore 14.
- Geometrical parameters of the individual magnetic shim coils 4 are determined. This step will be described in more detail below.
- Then, with the measured uncorrected magnetic field distribution and the geometrical parameters, optimal shim currents are determined. Optimal shim currents may be determined for example as explained before using a digital model or using a neural network.
- The individual coils 4 are driven with the optimal shim currents.

This procedure can be done only once for each diagnostic MR scan, but can also be performed several times or even continuously in real-time.

Geometrical parameters of the individual magnetic shim coils 4 may be determined using several different approaches. Some approaches according to this invention have already been described above. Here, some supplemental information on feasible strategies are given.

In Fig. 1, the magnetic coils 4 are connected to a signal evaluation unit 22. The unit 22 can record the voltages that are induced in the individual coils 4. The x-, y- and z-gradients are switched such that a temporally changing gradient field with different gradient directions is generated. For example, a gradient field might be generated along several directions along which the gradients could be driven in a ramp-up regime. It is also possible to simply use the imaging sequence that is applied as part of a usual MR imaging sequence protocol for updating the shim currents. The induced voltage data is recorded and used for further processing to determine location and orientation of the individual coils 4.

Fig. 2 illustrates a different MR arrangement 1, where a single-axis or multi-axes magnetic field sensor 9 is attached to an individual coil 4 at a location 20 on the coil 4. In practice, a shim insert 3 with several coils 4 is used similar to the insert 3 shown in Fig. 1. Onto each coil 4 at least one magnetic field sensor 9 may be attached.

Geometrical parameters might be determined by measuring the magnetic field strength while the gradients are switched. The gradients may be switched according to an additional protocol that is optimized for the shim calibration. However, also the standard diagnostic imaging sequence may be used for calibration. The measured magnetic field strength data is then used to determine position and/or orientation of the individual coils 4.

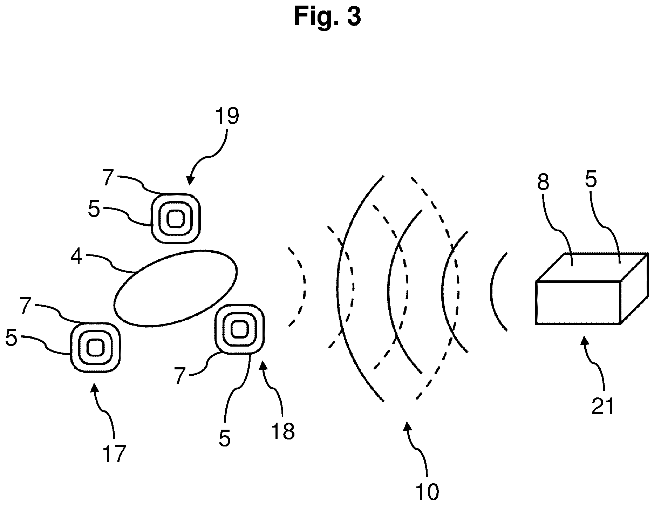

Fig. 3 illustrates a different method and arrangement to determine geometrical parameters. On each coil 4 of the shim insert 3, up to three, exactly three or even more than three signal communication devices 5 are attached. The locations 17, 18, 19 of attachment on the coils 4 are known. In the embodiment shown in Fig. 3, RFID (radio frequency identification) chips 7 are used as signal communication devices 5. A further signal communication device 5, here an RFID reader 8, is attached to a location 21 that remains fixed during an MR measurement or during execution of the shimming method. The further communication device 5 may be attached to the wall of a room at a location 21, cf. Fig. 1.

The measurement devices 5 and the further measurement device 5 can communicate a signal 10 between each other. The devices 5 are configured to be capable of determining the distance between the measurement devices 5, for example by measuring signal timing differences. The fixed further signal communication device 5 may send out a signal 10 to get a response from the signal communication devices 5 that are attached to the coils 4. From the time delay or attenuation of the received signals the positions and/or orientations of the magnetic coils 4 are determined.

For the determination of the geometrical parameters in this and other cases for example a triangulation algorithm may be used.

In summary, an MR arrangement 1 and a method to shim a magnetic field inside an MR apparatus 2 using a multi-coil shim insert 3 is described. After placing the shim insert 3 inside the bore 14 of the MR apparatus 2, geometrical parameters of the individual coils 4 of the shim insert 3 are determined.

### List of reference signs

- 1: MR arrangement
- 2: MR apparatus
- 3: shim insert
- 4: magnetic coil
- 5: signal communication device
- 6: filter device
- 7: RFID chip
- 8: RFID reader
- 9: magnetic field sensor
- 10: signal
- 11: subject
- 12: patient table
- 13: cable
- 14: bore
- 15: wall of magnet bore
- 16: wall of a room
- 17: a location on 4
- 18: another location on 4
- 19: another location on 4
- 20: another location on 4
- 21: location with known spatial coordinates
- 22: signal evaluation unit
- 23: imaging volume

## Claims

1. Method to shim a magnetic field inside an MR apparatus (2), whereby a shim insert (3) comprising several magnetic coils (4) is placed inside a bore (14) of the MR apparatus (2), wherein after placing the shim insert (3) inside the bore (14), geometrical parameters, which are positions and/or orientations, of the individual magnetic coils (4) of the shim insert (3) are determined, wherein an uncorrected magnetic field heterogeneity distribution of the magnetic field is measured and wherein optimal shim currents for the magnetic coils (4) are determined using the geometrical parameters and the uncorrected magnetic field heterogeneity distribution, **characterized in that** the optimal shim currents are determined by
- generating a digital model of the shim insert (3) such that magnetic field sensitivities of the individual coils (4) can be calculated automatically, whereby the magnetic field sensitivities depend on the geometrical parameters,
- finding optimal shim currents that minimize a deviation between the uncorrected measured magnetic field heterogeneity distribution and the magnetic field that is generated by the digital model of the shim insert (3) for the geometrical parameters.

2. Method to shim a magnetic field inside an MR apparatus (2), whereby a shim insert (3) comprising several magnetic coils (4) is placed inside a bore (14) of the MR apparatus (2), wherein after placing the shim insert (3) inside the bore (14), geometrical parameters, which are positions and/or orientations, of the individual magnetic coils (4) of the shim insert (3) are determined, wherin an uncorrected magnetic field heterogeneity distribution of the magnetic field is measured and wherein optimal shim currents for the magnetic coils (4) are determined using the geometrical parameters and the uncorrected magnetic field heterogeneity distribution, **characterized in that** the optimal shim currents are determined by
- training a neural network by simulating partially corrected magnetic field heterogeneity distributions using a digital model of the shim insert (3) by varying shim currents in the model, wherein the digital model of the shim insert (3) is generated such that magnetic field sensitivities of the individual coils can be calculated automatically, whereby the magnetic field sensitivities depend on the geometrical parameters,
- using the trained neural network to determine the optimal shim currents for the measured uncorrected magnetic
- field heterogeneity distribution.

3. Method according to claim 1 **characterized in that** the optimal shim currents are determined by finding optimal shim currents that minimize a deviation between the uncorrected measured magnetic field heterogeneity distribution and the magnetic field that is generated by the digital model of the shim insert (3) for the geometrical parameters by way of an automated optimization method.

4. Method according to claim 2
**characterized in that** optimal shim currents are determined by training the neural network by measuring partially corrected magnetic field heterogeneity distributions of the magnetic field with varying shim currents.

5. Method according to any one of the previous claims **characterized in that** distances between locations (17 to 20) on the individual coils (4) to a location (21) with known spatial coordinates are measured and that the measured distances are used to determine the geometrical parameters.

6. Method according to the previous claim, whereby distances to more than one location (17 to 20) on at least one individual coil (4) are measured.

7. Method according to one of the two previous claims **characterized in that** the distances are measured using a radiofrequency signal (10), in particular whereby the signal (10) has a frequency between 0,5 GHz and 2 GHz, preferably between 0,8 GHz and 1,2 GHz, and/or that the distances are measured by attaching signal communication devices (5) onto the individual coils (4) and a further signal communication device (5) at the location (21) with known spatial coordinates.

8. Method according to any one of the previous claims **characterized in that** a magnetic gradient field, preferably having a spatially constant gradient, is generated, that a field strength of the magnetic gradient field is measured at one or more locations (17 to 20) on the individual coils (4) and that the measured field strengths are used to determine the geometrical parameters, in particular whereby magnetic field sensors (9) are attached to the individual coils (4).

9. Method according to any one of the previous claims **characterized in that** a temporally varying magnetic gradient field, preferably having a spatially constant gradient, is generated, that the signals that are induced in the magnetic coils (4) by the magnetic gradient field are measured and that the measured signals are used to determine the geometrical parameters.

10. Method according to any one of the previous claims whereby optimal shim currents are updated at several time points during an MR acquisition.

11. Method according to the previous claim, whereby the geometrical parameters are determined at the several time points and/or whereby uncorrected magnetic field heterogeneity distributions are measured at the several time points.

12. MR arrangement (1) with an MR apparatus (2) and a shim insert (3) comprising several magnetic coils (4), **characterized in that** the MR arrangement (1) is configured to execute the method according to any of the previous claims.

13. MR arrangement (1) according to the previous claim, with an MR apparatus (2) and a shim insert (4) comprising several magnetic coils (4), which can move with respect to each other, **characterized in that** one or more signal communication devices (5, 7) and/or magnetic field sensors (9) are attached to the several magnetic coils (4) of the shim insert (3).

14. MR arrangement (1) according to the previous claim, whereby a further signal communication device (5, 8) is placed at a location (21) with known spatial coordinates.

15. Method according to any one of the claims 1 to 11, **characterized in that** an MR arrangement (1) according to any one of claims 12 to 14 is used to execute the method.

## Patentansprüche

1. Verfahren zum Ausgleichen eines Magnetfeldes in einer MR-Vorrichtung (2), wobei ein mehrere Magnetspulen (4) umfassender Ausgleichseinsatz (3) in eine Bohrung (14) der MR-Vorrichtung (2) platziert wird,
wobei nach dem Einsetzen des Ausgleichseinsatzes (3) in die Bohrung (14) geometrische Parameter, d. h. Positionen und/oder Ausrichtungen, der einzelnen Magnetspulen (4) des Ausgleichseinsatzes (3) bestimmt werden,
wobei eine unkorrigierte Magnetfeld-Heterogenitätsverteilung des Magnetfeldes gemessen wird, und
wobei optimale Ausgleichsströme für die Magnetspulen (4) anhand der geometrischen Parameter und der unkorrigierten Magnetfeld-Heterogenitätsverteilung bestimmt werden,
**dadurch gekennzeichnet, dass** die optimalen Ausgleichsströme durch Folgendes bestimmt werden:
- Erzeugen eines digitalen Modells des Ausgleichseinsatzes (3), so dass die Magnetfeldempfindlichkeiten der einzelnen Spulen (4) automatisch berechnet werden können, wobei die Magnetfeldempfindlichkeiten von den geometrischen Parametern abhängen,
- Suchen nach optimalen Ausgleichsströmen, die eine Abweichung zwischen der unkorrigierten gemessenen Magnetfeld-Heterogenitätsverteilung und dem Magnetfeld, das durch das digitale Modell des Ausgleichseinsatzes (3) für die geometrischen Parameter erzeugt wird, minimieren.

2. Verfahren zum Ausgleichen eines Magnetfeldes in einer MR-Vorrichtung (2), wobei ein mehrere Magnetspulen (4) umfassender Ausgleichseinsatz (3) in eine Bohrung (14) der MR-Vorrichtung (2) platziert wird,
wobei nach dem Einsetzen des Ausgleichseinsatzes (3) in die Bohrung (14) geometrische Parameter, d. h. Positionen und/oder Ausrichtungen, der einzelnen Magnetspulen (4) des Ausgleichseinsatzes (3) bestimmt werden,
wobei eine unkorrigierte Magnetfeld-Heterogenitätsverteilung des Magnetfeldes gemessen wird, und
wobei optimale Ausgleichsströme für die Magnetspulen (4) anhand der geometrischen Parameter und der unkorrigierten Magnetfeld-Heterogenitätsverteilung bestimmt werden,
**dadurch gekennzeichnet, dass** die optimalen Ausgleichsströme durch Folgendes bestimmt werden:
- Trainieren eines neuronalen Netzwerks durch Simulation von teilweise korrigierten Magnetfeld-Heterogenitätsverteilungen unter Verwendung eines digitalen Modells des Ausgleichseinsatzes (3) durch Variation der Ausgleichsströme im Modell,
wobei das digitale Modell des Ausgleichseinsatzes (3) so erstellt wird, dass die Magnetfeldempfindlichkeiten der einzelnen Spulen automatisch berechnet werden können, wobei die Magnetfeldempfindlichkeiten von den geometrischen Parametern abhängen,
- Verwenden des trainierten neuronalen Netzwerks zum Bestimmen der optimalen Ausgleichsströme für die gemessene unkorrigierte Magnetfeld-Heterogenitätsverteilung.

3. Verfahren nach Anspruch 1,
**dadurch gekennzeichnet, dass** die optimalen Ausgleichsströme bestimmt werden, indem optimale Ausgleichsströme gefunden werden, die eine Abweichung zwischen der unkorrigierten gemessenen Magnetfeld-Heterogenitätsverteilung und dem Magnetfeld, das durch das digitale Modell des Ausgleichseinsatzes (3) für die geometrischen Parameter erzeugt wird, mittels eines automatisierten Optimierungsverfahrens minimieren.

4. Verfahren nach Anspruch 2,
**dadurch gekennzeichnet, dass** die optimalen Ausgleichsströme durch Trainieren des neuronalen Netzwerks bestimmt werden, indem teilweise korrigierte Magnetfeld-Heterogenitätsverteilungen des Magnetfeldes mit variierenden Ausgleichsströmen gemessen werden.

5. Verfahren nach einem der vorhergehenden Ansprüche,
**dadurch gekennzeichnet, dass** Abstände zwischen Stellen (17 bis 20) auf den einzelnen Spulen (4) zu einer Stelle (21) mit bekannten Raumkoordinaten gemessen werden, und dass die gemessenen Abstände zum Bestimmen der geometrischen Parameter verwendet werden.

6. Verfahren nach dem vorhergehenden Anspruch, wobei Abstände zu mehr als einer Stelle (17 bis 20) auf mindestens einer einzelnen Spule (4) gemessen werden.

7. Verfahren nach einem der beiden vorhergehenden Ansprüche,
**dadurch gekennzeichnet, dass** die Abstände mit einem Hochfrequenzsignal (10) gemessen werden, wobei das Signal (10) insbesondere eine Frequenz zwischen 0,5 GHz und 2 GHz, vorzugsweise zwischen 0,8 GHz und 1,2 GHz, aufweist, und/oder dass die Abstände durch Anbringen von Signalkommunikationsvorrichtungen (5) an den einzelnen Spulen (4) und einer weiteren Signalkommunikationsvorrichtung (5) an der Stelle (21) mit bekannten Raumkoordinaten gemessen werden.

8. Verfahren nach einem der vorhergehenden Ansprüche,
**dadurch gekennzeichnet, dass** ein magnetisches Gradientenfeld, vorzugsweise mit räumlich konstantem Gradienten, erzeugt wird, dass eine Feldstärke des magnetischen Gradientenfeldes an einer oder mehreren Stellen (17 bis 20) auf den einzelnen Spulen (4) gemessen wird, und dass die gemessenen Feldstärken zur Bestimmung der geometrischen Parameter herangezogen werden, insbesondere, indem Magnetfeldsensoren (9) an den einzelnen Spulen (4) angebracht werden.

9. Verfahren nach einem der vorhergehenden Ansprüche,
**dadurch gekennzeichnet, dass** ein zeitlich veränderliches magnetisches Gradientenfeld, vorzugsweise mit räumlich konstantem Gradienten, erzeugt wird, dass die durch das magnetische Gradientenfeld in den Magnetspulen (4) induzierten Signale gemessen werden, und dass die gemessenen Signale zum Bestimmen der geometrischen Parameter verwendet werden.

10. Verfahren nach einem der vorhergehenden Ansprüche, wobei die optimalen Ausgleichsströme zu mehreren Zeitpunkten während einer MR-Akquisition aktualisiert werden.

11. Verfahren nach dem vorhergehenden Anspruch, wobei die geometrischen Parameter zu den verschiedenen Zeitpunkten bestimmt werden, und/oder wobei unkorrigierte Magnetfeld-Heterogenitätsverteilungen zu den verschiedenen Zeitpunkten gemessen werden.

12. MR-Anordnung (1) mit einer MR-Vorrichtung (2) und einem mehrere Magnetspulen (4) aufweisenden Ausgleichseinsatz (3),
**dadurch gekennzeichnet, dass** die MR-Anordnung (1) so konfiguriert ist, dass sie das Verfahren nach einem der vorhergehenden Ansprüche ausführt.

13. MR-Anordnung (1) nach dem vorhergehenden Anspruch, mit einer MR-Vorrichtung (2) und einem Ausgleichseinsatz (4), der mehrere Magnetspulen (4) umfasst, die sich gegeneinander bewegen können,
**dadurch gekennzeichnet, dass** eine oder mehrere Signalkommunikationsvorrichtungen (5, 7) und/oder Magnetfeldsensoren (9) an den verschiedenen Magnetspulen (4) des Ausgleichseinsatzes (3) angebracht sind.

14. MR-Anordnung (1) nach dem vorhergehenden Anspruch, wobei eine weitere Signalübertragungsvorrichtung (5, 8) an einer Stelle (21) mit bekannten Raumkoordinaten angeordnet ist.

15. Verfahren nach einem der Ansprüche 1 bis 11,
**dadurch gekennzeichnet, dass** eine MR-Anordnung (1) nach einem der Ansprüche 12 bis 14 zum Ausführen des Verfahrens verwendet wird.

## Revendications

1. Procédé pour corriger un champ magnétique à l'intérieur d'un appareil de résonance magnétique, RM, (2), dans lequel un insert de correction (3) comprenant plusieurs bobines magnétiques (4) est placé à l'intérieur d'un alésage (14) de l'appareil RM (2), dans lequel après avoir placé l'insert de correction (3) à l'intérieur de l'alésage (14), des paramètres géométriques, qui sont des positions et/ou des orientations, des bobines magnétiques individuelles (4) de l'insert de correction (3) sont déterminés, dans lequel une distribution d'hétérogénéité de champ magnétique non corrigée du champ magnétique est mesurée et dans lequel des courants de correction optimaux pour les bobines magnétiques (4) sont déterminés à l'aide des paramètres géométriques et de la distribution d'hétérogénéité de champ magnétique non corrigée, **caractérisé en ce que** les courants de correction optimaux sont déterminés par l'intermédiaire des étapes consistant à
- générer un modèle numérique de l'insert de correction (3) de sorte que les sensibilités au champ magnétique des bobines individuelles (4) puissent être calculées automatiquement, dans lequel les sensibilités au champ magnétique dépendant des paramètres géométriques,
- trouver des courants de correction optimaux qui minimisent un écart entre la distribution d'hétérogénéité de champ magnétique mesurée non corrigée et le champ magnétique qui est généré par le modèle numérique de l'insert de correction (3) pour les paramètres géométriques.

2. Procédé pour caler un champ magnétique à l'intérieur d'un appareil de RM (2), dans lequel un insert de correction (3) comprenant plusieurs bobines magnétiques (4) est placé à l'intérieur d'un alésage (14) de l'appareil de RM (2), dans lequel après avoir placé l'insert de correction (3) à l'intérieur de l'alésage (14), des paramètres géométriques, qui sont des positions et/ou des orientations, des bobines magnétiques individuelles (4) de l'insert de correction (3) sont déterminés, dans lequel une distribution d'hétérogénéité de champ magnétique non corrigée du champ magnétique est mesurée et dans lequel des courants de correction optimaux pour les bobines magnétiques (4) sont déterminés à l'aide des paramètres géométriques et de la distribution d'hétérogénéité de champ magnétique non corrigée, **caractérisé en ce que** les courants de correction optimaux sont déterminés par l'intermédiaire des étapes consistant à
- former un réseau neuronal en simulant des distributions d'hétérogénéité de champ magnétique partiellement corrigées à l'aide d'un modèle numérique de l'insert de correction (3) en faisant varier des courants de correction dans le modèle, dans lequel le modèle numérique de l'insert de correction (3) est généré de telle sorte que les sensibilités de champ magnétique des bobines individuelles peuvent être calculées automatiquement, moyennant quoi les sensibilités de champ magnétique dépendant des paramètres géométriques,
- utiliser le réseau neuronal entraîné pour déterminer les courants de correction optimaux pour la distribution d'hétérogénéité de champ magnétique non corrigée mesurée.

3. Procédé selon la revendication 1, **caractérisé en ce que** les courants de correction optimaux sont déterminés en trouvant des courants de correction optimaux qui minimisent un écart entre la distribution d'hétérogénéité de champ magnétique mesurée non corrigée et le champ magnétique qui est généré par le modèle numérique de l'insert de correction (3) pour les paramètres géométriques au moyen d'un procédé d'optimisation automatisé.

4. Procédé selon la revendication 2, **caractérisé en ce que** des courants de compensation optimaux sont déterminés en formant le réseau neuronal en mesurant des distributions d'hétérogénéité de champ magnétique partiellement corrigées du champ magnétique avec des courants de compensation variables.

5. Procédé selon l'une quelconque des revendications précédentes, **caractérisé en ce que** des distances entre des emplacements (17 à 20) sur les bobines individuelles (4) jusqu'à un emplacement (21) avec des coordonnées spatiales connues sont mesurées et **en ce que** les distances mesurées sont utilisées pour déterminer les paramètres géométriques.

6. Procédé selon la revendication précédente, dans lequel les distances jusqu'à plus d'un emplacement (17 à 20) sur au moins une bobine individuelle (4) sont
mesurées.

7. Procédé selon l'une des deux revendications précédentes, **caractérisé en ce que** les distances sont mesurées à l'aide d'un signal radiofréquence (10), en particulier dans lequel le signal (10) a une fréquence comprise entre 0,5 GHz et 2 GHz, de préférence entre 0,8 GHz et 1,2 GHz, et/ou **en ce que** les distances sont mesurées en fixant des dispositifs de communication de signal (5) sur les bobines individuelles (4) et un dispositif de communication de signal supplémentaire (5) à l'emplacement (21) avec des coordonnées spatiales connues.

8. Procédé selon l'une quelconque des revendications précédentes, **caractérisé en ce qu'**un champ de gradient magnétique, ayant de préférence un gradient spatialement constant, est généré, **en ce qu'**une intensité de champ du champ de gradient magnétique est mesurée au niveau d'un ou plusieurs emplacements (17 à 20) sur les bobines individuelles (4) et **en ce que** les intensités de champ mesurées sont utilisées pour déterminer les paramètres géométriques, en particulier dans lequel des capteurs de champ magnétique (9) sont fixés aux bobines individuelles (4).

9. Procédé selon l'une quelconque des revendications précédentes, **caractérisé en ce qu'**un champ de gradient magnétique variant dans le temps, présentant de préférence un gradient constant dans l'espace, est généré, **en ce que** les signaux qui sont induits dans les bobines magnétiques (4) par le champ de gradient magnétique sont mesurés, et **en ce que** les signaux mesurés sont utilisés pour déterminer les paramètres géométriques.

10. Procédé selon l'une quelconque des revendications précédentes, dans lequel des courants de correction optimaux sont mis à jour à plusieurs moments au cours d'une acquisition RM.

11. Procédé selon la revendication précédente, dans lequel les paramètres géométriques sont déterminés aux différents points de temps et/ou dans lequel des distributions d'hétérogénéité de champ magnétique non corrigées sont mesurées aux différents points de temps.

12. Agencement de RM (1) avec un appareil de RM (2) et un insert de correction (3) comprenant plusieurs bobines magnétiques (4), **caractérisé en ce que** l'agencement de RM (1) est configuré pour exécuter le procédé selon l'une quelconque des revendications précédentes.

13. Agencement de RM (1) selon la revendication précédente, avec un appareil de RM (2) et un insert de correction (4) comprenant plusieurs bobines magnétiques (4), qui peuvent se déplacer les unes par rapport aux autres, **caractérisé en ce qu'**un ou plusieurs dispositifs de communication de signaux (5, 7) et/ou capteurs de champ magnétique (9) sont fixés aux plusieurs bobines magnétiques (4) de l'insert de correction (3).

14. Agencement de RM (1) selon la revendication précédente, dans lequel un dispositif de communication de signal supplémentaire (5, 8) est placé en un emplacement (21) avec des coordonnées spatiales connues.

15. Procédé selon l'une quelconque des revendications 1 à 11, **caractérisé en ce qu'**un agencement de RM (1) selon l'une quelconque des revendications 12 à 14 est utilisé pour exécuter le procédé.
